# EUROPÄISCHE PATENTANMELDUNG

(11) **EP 2 373 142 A2**
(43) Veröffentlichungstag der Anmeldung: **05.10.2011**
(21) Anmeldenummer: 11159850.4
(22) Anmeldetag: 25.03.2011
(51) Int. Cl.: H05K 7/20, F21V 29/00

(54) **Betriebsschaltung zum Betreiben eines Lüfters für ein Leuchtmodul**

(30) Priorität: 29.03.2010 DE 102010013310
(71) Anmelder: Panasonic Electric Works Vossloh-Schwabe GmbH, 58509 Lüdenscheid (DE)
(72) Erfinder: Dieker, Henning, 46342, Velen (DE)
(74) Vertreter: Rüger, Barthelt & Abel Patentanwälte

(57) **Zusammenfassung**

Die Erfindung betrifft eine Betriebsschaltung für einen Lüfter (14), der zur Kühlung eines Leuchtmoduls (13) dient. Der Lüfter (14) wird über eine Steuerschaltung (17) angesteuert. Das Leuchtmodul (13) ist über einen Ausgangskreis (16) an einen Ausgang (11) eines Vorschaltgeräts (12) angeschlossen. Zur Vereinfachung des Aufbaus des Vorschaltgeräts (12) sind sowohl die Steuerschaltung (17), als auch der Lüfter (14) über den Ausgangskreis (16) mit demselben Ausgang (11) an das Vorschaltgerät (12) angeschlossen. Auf diese Weise werden das Leuchtmodul (13) einerseits und der Lüfter (14) andererseits über denselben Ausgang (11) des Vorschaltgeräts (12) mit elektrischer Energie versorgt.

## Beschreibung

Die Erfindung betrifft eine Betriebsschaltung zum Betreiben eines Lüfters, wie er insbesondere zum Kühlen eines Leuchtmoduls verwendet wird. Das Leuchtmodul weist beispielsweise mehrere Leuchtelemente und insbesondere mehrere Leuchtdioden auf. Es ist an einen Ausgangskreis eines Vorschaltgeräts angeschlossen, der das Leuchtmodul mit elektrischer Energie versorgt.

Leuchtmodule müssen wegen der Temperaturentwicklung der Leuchtelemente in vielen Fällen gekühlt werden. Hierfür sind Lüfter vorgesehen. Die bisher bekannten Betriebsschaltungen zum Betreiben des Leuchtmoduls sowie des Lüfters sind aufwendig und teuer. In der Regel wird ein spezielles Vorschaltgerät oder Netzteil verwendet, das einen Anschluss für den Ausgangskreis und das Leuchtmodul und einen weiteren Versorgungsanschluss für den Lüfter und dessen Steuerschaltung zur Verfügung stellt.

Aus der DE 10 2007 040 444 A1 ist beispielsweise eine LED-Lampe bekannt, die zur Erhöhung der Kühlleistung einen Lüfter aufweisen kann. Die Lüfterleistung kann temperaturabhängig geregelt werden. Die elektrische Versorgung und Ansteuerung des Lüfters ist im Einzelnen nicht offenbart.

Auch aus EP 1 561 993 A2 ist es bekannt, einen motorangetriebenen Ventilator zur Kühlung einer LED-Lampe einzusetzen. Beispielsgemäß wird ein Gleichstrommotor verwendet, der über einen Gleichrichter mit einer Gleichspannung ver-WO 2008/037992 sowie US 2003/0040200 A1 beschreiben LED-Lampen, die über einen Lüfter gekühlt werden. Die elektrische Versorgung und Ansteuerung des Lüfters ist dort nicht beschrieben.

Es kann als eine Aufgabe der vorliegenden Erfindung angesehen werden, eine Betriebsschaltung für einen Lüfter zur Kühlung eines Leuchtmoduls zu schaffen, die einfach und kostengünstig realisiert werden kann.

Diese Aufgabe wird durch eine Betriebsschaltung mit den Merkmalen des Patentanspruches 1 gelöst. Das Vorschaltgerät weist einen Ausgang auf, an den ein Ausgangskreis angeschlossen ist. Der Ausgangskreis dient zur Versorgung des Leuchtmoduls mit elektrischer Energie. Die Steuerschaltung zur Ansteuerung des Lüfters ist ausschließlich mit dem Ausgangskreis elektrisch verbunden. Ein weiterer Versorgungsausgang des Vorschaltgeräts zur Versorgung der Steuerschaltung oder des Lüfters kann entfallen. Beim Ausführungsbeispiel ist der Lüfter gemeinsam mit der Steuerschaltung parallel oder in Reihe zum Leuchtmodul bzw. zu einem Teil der im Leuchtmodul vorgesehenen Leuchtelemente geschaltet. Eine besondere Ausgestaltung des Vorschaltgeräts ist nicht notwendig. Bei ausreichender Leistung des Vorschaltgeräts können sowohl der Lüfter als auch das Leuchtmodul über einen gemeinsamen Ausgang mit elektrischer Energie versorgt werden. Eine Steuerschaltung ermöglicht den Betrieb des Lüfters am Ausgangskreis zusammen mit dem Leuchtmodul.

Das Leuchtmodul weist vorzugsweise eine Reihenschaltung von mehreren Leuchtelementen und insbesondere Leuchtdioden auf. Bei dieser Ausgestaltung kann der Lüfter bzw. die Steuerschaltung parallel zu einem Teil der Leuchtelemente geschaltet sein. Die an den Leuchtelementen abfallende Spannung wird der Steuerschaltung bzw. dem Lüfter zum Betrieb zur Verfügung gestellt. Insbesondere ist es dabei zweckmäßig, wenn die Steuerschaltung so dimensioniert ist, dass der Lüfterstrom deutlich geringer ist als der am Ausgang des Vorschaltgeräts in den Ausgangskreis gelieferte Ausgangsstrom. Vorzugsweise kann der Lüfterstrom 5 bis 20% und insbesondere 10% des Ausgangsstroms betragen. Beispielsweise beträgt der Ausgangsstrom etwa 500 mA und der Lüfterstrom mithin bis zu etwa 100mA. Der Lüfterstrom kann zum Beispiel durch einen Widerstand begrenzt werden, der mit dem Lüfter in Reihe geschaltet ist.

Bei einer bevorzugten Ausgestaltung ist in Reihe mit dem Lüfter eine dem Lüfterstrom beeinflussende Einrichtung geschaltet, beispielsweise ein temperaturabhängiger Widerstand, wodurch sehr einfach ein temperaturabhängiger Lüfterstrom und damit eine temperaturabhängige Lüftersteuerung erreicht werden kann.

Eine Leistungsregelung des Lüfters kann bei einer bevorzugten Ausgestaltung auch dadurch erreicht werden, dass die Steuerschaltung einen Längsregler für den Lüfter aufweist.

Es ist ferner möglich, die Lüfterspannung oder den Lüfterstrom durch die Steuerschaltung konstant vorzugeben. Zur temperaturabhängigen Lüftersteuerung kann die Lüfterspannung oder der Lüfterstrom auch variabel in Abhängigkeit von der erfassten Temperatur am Leuchtmodul eingestellt werden. Zu diesem Zweck weist die Steuerschaltung vorzugsweise einen Heißleiter (NTC) auf.

Schließlich ist bei einer abgewandelten Ausführungsform der Erfindung die Steuerschaltung bzw. der Lüfter in Reihe zum Leuchtmodul geschaltet. Bei dieser Ausgestaltung wird der Strom durch das Leuchtmodul nicht verändert.

Vorteilhafte Ausgestaltungen der Erfindung ergeben sich aus den abhängigen Patentansprüchen sowie der Beschreibung. Die Beschreibung beschränkt sich dabei auf wesentliche Merkmale der Erfindung. Die Zeichnung ist ergänzend heranzuziehen. Es zeigen:
Figur 1 ein Blockschaltbild der Betriebsschaltung,
Figur 2 ein erstes Ausführungsbeispiel für die Steuerschaltung zur Ansteuerung des Lüfters,
Figur 3 ein zweites Ausführungsbeispiel der Steuerschaltung mit einem Längsregler,
Figur 4 ein drittes Ausführungsbeispiel der Steuerschaltung mit einem gesteuerten Schalter,
Figur 5 einen parallel zum Lüftermotor geschalteten Kondensator und
Figur 6 ein viertes Ausführungsbeispiel der Steuerschaltung für den Lüfter, die in Reihe zum Leuchtmodul geschaltet ist.

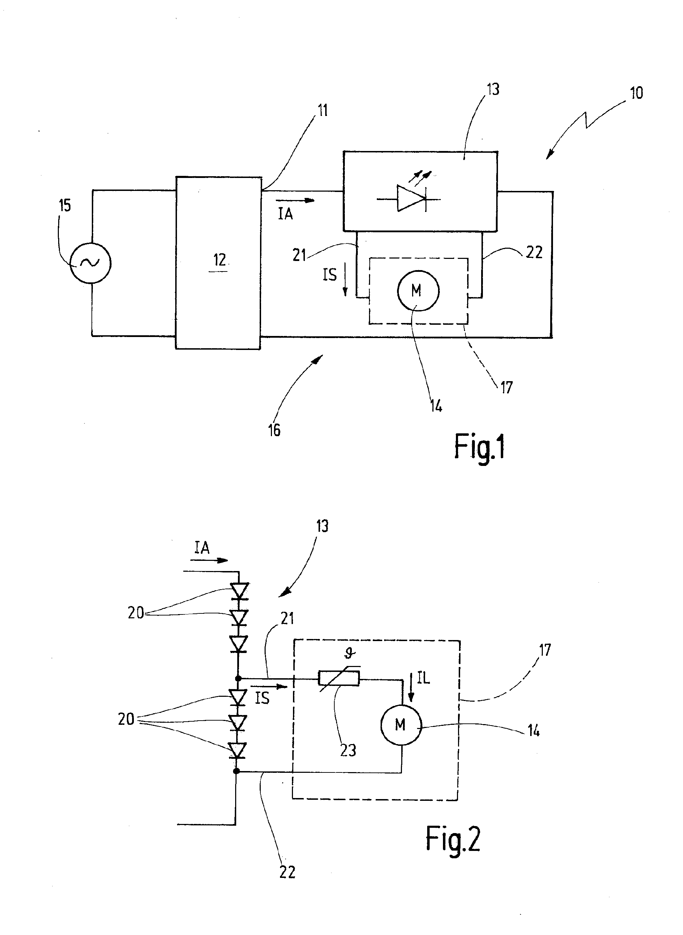

Figur 1 zeigt ein Blockschaltbild einer Betriebsschaltung 10, die dazu dient am Ausgang 11 eines Vorschaltgeräts 12 ein Leuchtmodul 13 sowie einen Lüfter 14 zu betreiben. In der Zeichnung ist der Lüfter 14 durch den Lüftermotor M dargestellt. Das Vorschaltgerät ist an eine Netzspannungsquelle 15 angeschlossen. An seinem Ausgang 11 ist ein Ausgangskreis 16 elektrisch angeschlossen, der zur elektrischen Versorgung des Leuchtmoduls 13 dient. Der Ausgangskreis 16 enthält ferner eine Steuerschaltung 17 zur Ansteuerung des Lüfters 14. Sowohl das Leuchtmodul 13, als auch die Steuerschaltung 17 und der Lüfter 14 sind damit gemeinsam an denselben Ausgang 11 des Vorschaltgeräts 12 angeschlossen. Beim bevorzugten Ausführungsbeispiel ist die den Lüfter 14 ansteuernde Steuerschaltung 17 parallel oder in Reihe zum Leuchtmodul 13 geschaltet.

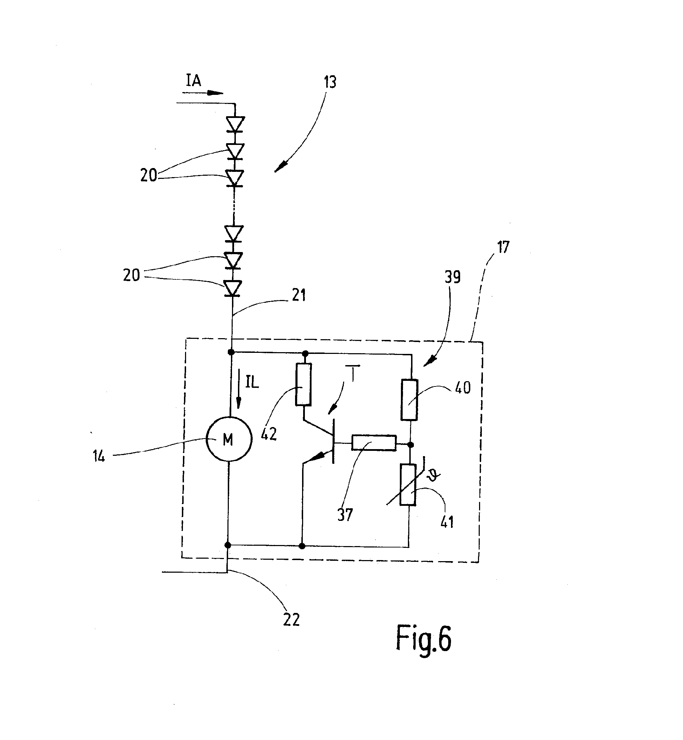

Das Leuchtmodul 13 weist beim Ausführungsbeispiel eine Reihenschaltung von mehreren Leuchtelementen und vorzugsweise mehreren Leuchtdioden 20 auf, wie dies in den Figuren 2 oder 6 veranschaulicht ist. Die Reihenschaltung kann beispielsweise 10 bis 20 Leuchtdioden 20 aufweisen. Die Steuerschaltung 17 ist mit dem Leuchtmodul 13 über einen ersten Anschluss 21 und einen zweiten Anschluss 22 elektrisch verbunden. Beim ersten Ausführungsbeispiel nach Figur 2 ist die Steuerschaltung 17 parallel zu einem Teil der Leuchtdioden 20 des Leuchtmoduls 13 geschaltet. Beispielsgemäß sind drei Leuchtdioden 20 zwischen den beiden Anschlüssen 21, 22 in Reihe geschaltet. Die Anzahl der dort vorhandenen Leuchtdioden 20 hängt davon ab, welche Ausgangsspannung bzw. welcher Ausgangsstrom am Ausgang 11 des Vorschaltgeräts 12 bereitgestellt wird und wie viele Leuchtdioden 20 bzw. andere Leuchtelemente im Leuchtmodul 13 in Reihe geschaltet sind. Welche aufeinanderfolgenden Leuchtdioden 20 parallel zur Steuerschaltung 17 geschaltet werden ist frei wählbar.

Die Steuerschaltung 17 weist beim ersten Ausführungsbeispiel einen temperaturabhängigen Vorwiderstand 23 auf. Der temperaturabhängige Vorwiderstand 23 ist als Heißleiter ausgestaltet, so dass der Strom durch den Lüfter 14 ansteigt, wenn die Temperatur des Leuchtmoduls 13 zunimmt. Auf diese Weise wird bei ansteigender Temperatur die Lüfterleistung gesteigert und damit die Kühlung verbessert. Gleichzeitig sinkt der Strom durch die Leuchtdioden 20, die parallel zur Steuerschaltung 17 geschaltet sind, so dass deren thermische Leistung abnimmt. Auch dies trägt zur Abkühlung des Leuchtmoduls 13 bei. Die Steuerschaltung 17 wird dabei so auf das Leuchtmodul 13 abgestimmt, dass der durch die Steuerschaltung 17 aufgenommene Steuerstrom IS in etwa 10% vom am Ausgang 11 des Vorschaltgeräts 12 bereitgestellten Ausgangsstrom IA beträgt. Das erste Ausführungsbeispiel der Steuerschaltung 17 nach Figur 2 stellt somit eine temperaturabhängige Leistungsregelung des Lüfters 14 zur Verfügung. Der Steuerstrom IS entspricht hierbei dem Lüfterstrom IL, der dem Lüftermotor M bereitgestellt wird.

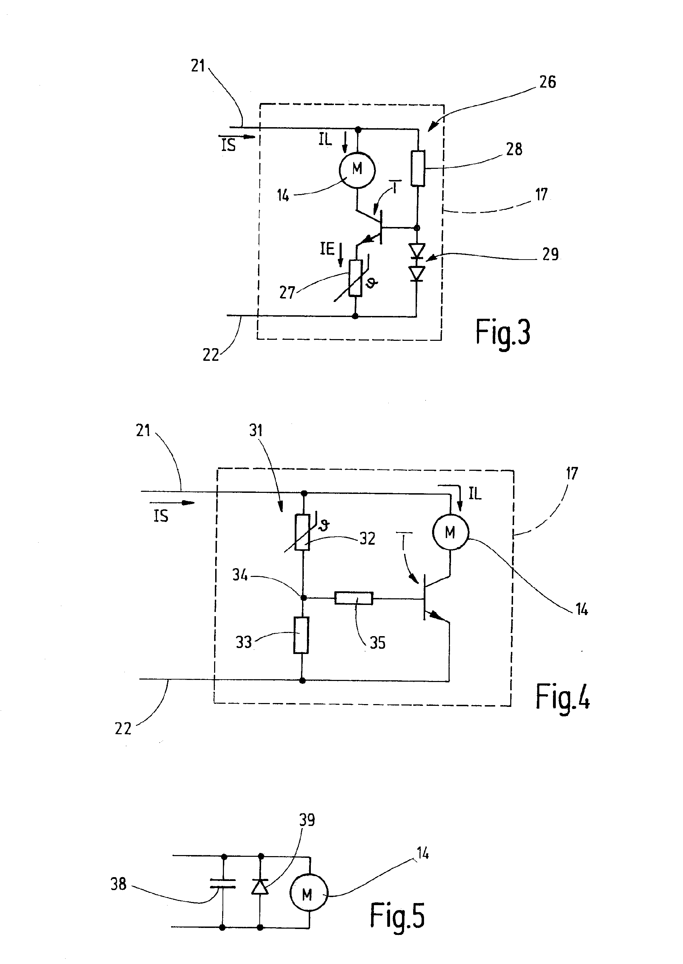

In Figur 3 ist ein zweites Ausführungsbeispiel der Steuerschaltung 17 dargestellt. Der Anschluss der Steuerschaltung 17 an das Leuchtmodul 13 entspricht dem zweiten Ausführungsbeispiel gemäß Figur 2. Auch hier ist die Steuerschaltung 17 parallel zu einem Teil der Leuchtelemente 20 des Leuchtmoduls 13 geschaltet. Die Steuerschaltung 17 weist beim zweiten Ausführungsbeispiel einen Längsregler 26 auf, der den Lüfterstrom IL vorgibt. Der Lüftermotor M des Lüfters 14 ist mit dem ersten Anschluss 21 verbunden. In Reihe zum Lüftermotor M ist ein Transistor T geschaltet, dessen Kollektor mit dem Lüftermotor M und dessen Emitter mit einem Heißleiter 27 elektrisch verbunden ist. Der Heißleiter 27 wiederum ist mit dem zweiten Anschluss 22 elektrisch verbunden. Die Basis des Transistors T ist einerseits über einen Basiswiderstand 28 mit dem ersten Anschluss 21 und andererseits über eine Diodenschaltung 29 mit dem zweiten Anschluss 22 elektrisch verbunden. Die Diodenschaltung 29 weist beispielsgemäß eine Reihenschaltung von zwei Dioden auf. Alternativ hierzu könnte die Diodenschaltung 29 auch eine Zenerdiode enthalten. Die Diodenschaltung 29 sorgt dafür, dass der Transistor T in seinem leitenden Zustand verbleibt.

Wenn die Temperatur des Leuchtmoduls 13 steigt, sinkt der Widerstand der Heißleiters 27, wodurch sich der Emitterstrom IE des Transistors T erhöht. Dadurch steigt auch der Lüfterstrom IL, so dass die vom Lüfter 14 zur Verfügung gestellte Kühlleistung zunimmt. Sinkt umgekehrt die Temperatur des Leuchtmoduls 13 ab, erhöht sich der Widerstand des Heißleiters 27 und sowohl der Emitterstrom IE als auch der Lüfterstrom IL durch den Lüftermotor M nehmen ab. Die Kühlleistung des Lüfters 14 reduziert sich entsprechend. Der Längsregler 26 regelt damit temperaturabhängig den Lüfterstrom IL und sorgt für eine temperaturabhängige Kühlleistung des Lüfters 14.

Eine andere Ausgestaltung zur Steuerung des Lüftermotors M ergibt sich durch das dritte Ausführungsbeispiel der Steuerschaltung 17 nach Figur 4. Der Anschluss der Steuerschaltung 17 an das Leuchtmodul 13 über die Anschlüsse 21, 22 entspricht dem der ersten beiden Ausführungsbeispiele gemäß der Figuren 2 und 3. Zwischen dem ersten Anschluss 21 und dem zweiten Anschluss 22 ist ein Spannungsteiler 31 geschaltet, bei dem in Reihe ein Heißleiter 32 sowie ein Spannungsteilerwiderstand 33 geschaltet sind. Der Mittenabgriff 34 des Spannungsteilers 31 ist über einen Basiswiderstand 35 mit der Basis eines Transistors T elektrisch verbunden. Der Kollektor der Transistors T ist mit dem Lüftermotor M verbunden, der wiederum an den ersten Anschluss 21 angeschlossen ist. Der Emitter des Transistors T ist mit dem zweiten Anschluss 22 verbunden.

Das dritte Ausführungsbeispiel der Steuerschaltung 17 arbeitet wie folgt:
Bei einer geringen Temperatur, die keinen Lüfterbetrieb erfordert, ist der Widerstand des Heißleiters 32 im Verhältnis zum Widerstand des Spannungsteilerwiderstands 33 so groß, dass die Basisemitterspannung am Transistor T kleiner ist als ein Schwellenwert (abhängig vom Transistor z.B. 0 bis 0,7 V), wodurch der Transistor T sperrt. Der Lüfterstrom IL durch den Motor M des Lüfters 14 ist damit gleich null und der Lüfter 14 wird nicht betrieben. Steigt die Temperatur des Leuchtmoduls 13 soweit an, dass die Basisemitterspannung des Transistors T den Schwellenwert überschreitet, wird der Transistor T leitend und es fliest ein Lüfterstrom IL durch den Lüftermotor M. Die Steuerschaltung 17 schaltet den Lüftermotor M somit temperaturabhängig ein bzw. aus. Der Lüftermotor M wird sozusagen temperaturabhängig getaktet betrieben. Eine Drehzahlregelung des Lüftermotors M abhängig von der Temperatur findet bei dieser Ausgestaltung im Unterschied zum ersten und zweiten Ausführungsbeispiel gemäß der Figuren 2 und 3 nicht statt.

Wie dies in Figur 5 veranschaulicht ist, können parallel zum Lüftermotor M des Lüfters 14 ein Kondensator 38 sowie eine Diode 39 geschaltet sein, um Spannungsschwankungen am Lüftermotor M auszugleichen. Dies kann bei allen drei oben beschriebenen Ausführungsformen vorgesehen sein.

Bei einer abgewandelten Ausführungsform der Steuerschaltung ist es auch möglich, den Lüftermotor M eine konstante Lüfterspannung oder einen konstanten Lüfterstrom IL zur Verfügung zu stellen. Beispielsweise könnte der temperaturabhängige Widerstand 23 beim ersten Ausführungsbeispiel nach Figur 2 durch einen ohmschen Widerstand ersetzt werden, wodurch der Lüfter 14 mit gleichbleibender Lüfterleistung betrieben wird.

Bei einem vierten Ausführungsbeispiel der Steuerschaltung 17 ist diese in Reihe zum Leuchtmodul 13 geschaltet, wie dies in Figur 6 veranschaulicht ist. Der Lüftermotor M ist dabei zwischen den beiden Anschlüssen 21 und 22 vorgesehen. Parallel zum Lüftermotor M ist ein Transistor T geschaltet. Dessen Basis ist über einen Basiswiderstand 37 mit einem Mittenabgriff 38 eines Spannungsteilers 39 verbunden. Der Spannungsteiler 39 weist einen Spannungsteilerwiderstand 40 auf, der zwischen den Mittenabgriff 38 und den ersten Anschluss 21 geschaltet ist. Der Spannungsteiler 39 weist ferner einen Heißleiter 41 auf, der zwischen den Mittenabgriff 38 und dem zweiten Anschluss 22 geschaltet ist. Der Kollektor des Transistors T ist mit dem ersten Anschluss 21 und der Emitter mit dem zweiten Anschluss 22 verbunden. Der Kollektor des Transistors ist über einen Widerstand 42 mit dem ersten Anschluss 21 verbunden.

Das vierte Ausführungsbeispiel der Steuerschaltung 17 arbeitet wie folgt.

Bei einer geringen Temperatur des Leuchtmoduls 13 ist der Widerstand des Heißleiters 41 groß im Vergleich zum Widerstandswert des Spannungsteilerwiderstands 40. Die Basisemitterspannung des Transistors T ist daher größer als ein Schwellenwert, so dass der Transistor T leitet. Der Widerstand 42 ist so dimensioniert, dass der Lüfetrstrom IL reicht dabei nicht ausreicht, um den Lüftermotor M zu betreiben. Der Lüfter 14 steht somit still. Steigt die Temperatur des Leuchtmoduls an, sinkt der Widerstandswert des Heißleiters 41. Erreicht die Temperatur einen vorgegebenen Temperatur-Schwellenwert ist die Basisemitterspannung des Transistors T kleiner als der Schwellenwert, so dass der Transistor T sperrt. Durch den Lüftermotor M fließt dann ein Lüfterstrom IL, so dass der Lüfter 14 eingeschaltet wird, wenn der Transistor T in seinen Sperrzustand übergeht.

Die Erfindung betrifft eine Betriebsschaltung für einen Lüfter 14, der zur Kühlung eines Leuchtmoduls 13 dient. Der Lüfter 14 wird über eine Steuerschaltung 17 angesteuert. Das Leuchtmodul 13 ist über einen Ausgangskreis 16 an einen Ausgang 11 eines Vorschaltgeräts 12 angeschlossen. Zur Vereinfachung des Aufbaus des Vorschaltgeräts 12 sind sowohl die Steuerschaltung 17, als auch der Lüfter 14 über den Ausgangskreis 16 mit demselben Ausgang 11 an das Vorschaltgerät 12 angeschlossen. Auf diese Weise werden das Leuchtmodul 13 einerseits und der Lüfter 14 andererseits über denselben Ausgang 11 des Vorschaltgeräts 12 mit elektrischer Energie versorgt.

### Bezugszeichenliste:

- 10: Betriebsschaltung
- 11: Ausgang v. 12
- 12: Vorschaltgerät
- 13: Leuchtmodul
- 14: Lüfter
- 15: Netzspannungsquelle
- 16: Ausgangskreis
- 17: Steuerschaltung

- 20: Leuchtdiode
- 21: Anschluss
- 22: Anschluss
- 23: Vorwiderstand

- 26: Längsregler
- 27: Heißleiter
- 28: Basiswiderstand
- 29: Diodenschaltung

- 31: Spannungsteiler
- 32: Heißleiter
- 33: Spannungsteilerwiderstand
- 34: Mittenabgriff
- 35: Basiswiderstand

- 37: Basiswiderstand
- 38: Mittenabgriff
- 39: Spannungsteiler
- 40: Spannungsteilerwiderstand
- 41: Heißleiter
- 42: Widerstand

- IA: Ausgangsstrom
- IL: Lüfterstrom
- IS: Steuerstrom
- T: Transistor

## Patentansprüche

1. Betriebsschaltung zum Betreiben eines Lüfters (14) für ein Leuchtmodul (13),
mit einem an einen Ausgang des Vorschaltgeräts (12) angeschlossenen Ausgangskreis (16) der zur Versorgung des Leuchtmoduls (13) mit elektrischer Energie dient,
mit einer Steuerschaltung (17) zur Ansteuerung des Lüfters (14), wobei sowohl der Lüfter (14) als auch die Steuerschaltung (17) zur Versorgung mit elektrischer Energie an den Ausgangskreis (16) angeschlossen sind.

2. Betriebsschaltung nach Anspruch 1,
**dadurch gekennzeichnet, dass** das Leuchtmodul (13) eine Reihenschaltung mehrerer Leuchtelemente, insbesondere Leuchtdioden (20), aufweist.

3. Betriebsschaltung nach Anspruch 2,
**dadurch gekennzeichnet, dass** der Lüfter (14) parallel zu einem Teil der Leuchtelemente (20) geschaltet ist.

4. Betriebsschaltung nach Anspruch 1,
**dadurch gekennzeichnet, dass** in Reihe mit dem Lüfter (14) eine den Lüfterstrom (IL) beeinflussende Einrichtung (23) geschaltet ist.

5. Betriebsschaltung nach Anspruch 4,
**dadurch gekennzeichnet, dass** es sich bei der den Lüfterstrom (IL) beeinflussenden Einrichtung um einen temperaturabhängigen Widerstand (23) handelt.

6. Betriebsschaltung nach Anspruch 1,
**dadurch gekennzeichnet, dass** die Steuerschaltung (17) einen Längsregler (16) für den Lüfter (14) aufweist.

7. Betriebsschaltung nach Anspruch 1,
**dadurch gekennzeichnet, dass** der Lüfterstrom (IL) etwa 5 bis 20% des vom Vorschaltgerät (12) in den Ausgangskreis (16) abgegebenen Ausgangsstroms (IA) beträgt.

8. Betriebsschaltung nach Anspruch 1,
**dadurch gekennzeichnet, dass** die Steuerschaltung (17) dem Lüfter (14) eine konstante Lüfterspannung oder einen konstanten Lüfterstrom (IL) bereitstellt.

9. Betriebsschaltung nach Anspruch 1,
**dadurch gekennzeichnet, dass** die Steuerschaltung (17) dem Lüfter (14) eine temperaturabhängige Lüfterspannung oder einen temperaturabhängigen Lüfterstrom (IL) bereitstellt.

10. Betriebsschaltung nach Anspruch 1,
**dadurch gekennzeichnet, dass** der Lüfter (14) zum Leuchtmodul (13) in Reihe geschaltet ist.
